# EUROPEAN PATENT APPLICATION

(11) **EP 1 132 951 A1**
(43) Date of publication of application: **12.09.2001**
(21) Application number: 00308689.9
(22) Date of filing: 03.10.2000
(51) Int. Cl.: H01L 21/306

(54) **Process of cleaning silicon prior to formation of the gate oxide**

(30) Priority: 10.03.2000 US 523331
(71) Applicant: LUCENT TECHNOLOGIES INC., Murray Hill, New Jersey 07974-0636 (US)
(72) Inventor: Rosamilia, Joseph Mark, Berkeley Heights, New Jersey 07922 (US); Sapjeta, Barbara Joyce, Morris Plains, New Jersey 07950 (US)
(74) Representative: Williams, David John

(57) **Abstract**

The process involves an improved pre-gate cleaning technique that results in a smoother wafer surface than previous techniques. In particular, the pre-gate cleaning technique involves a step of rinsing a silicon wafer with ozonated water. Typically, the technique involves the sequential steps of cleaning the silicon wafer with HF, performing the ozonated water rinse, and treating with an SC1 solution. The oxygen in the ozonated water induces formation of a more uniform chemical (as opposed to native) oxide layer, which etches more uniformly in the SC1

## Description

### BACKGROUND OF THE INVENTION

### Field of the Invention

The invention relates to a process for semiconductor device fabrication, in particular, steps involving cleaning of a silicon substrate prior to formation of a gate oxide.

### Discussion of the Related Art

One step involved in semiconductor device fabrication is cleaning of silicon wafer substrates before further processing steps, e.g., before formation of a gate oxide. Such cleaning is performed to remove particulate contaminates, organics, and/or metals as well as any native oxide, both of which tend to interfere with subsequent processing. In particular, insufficient cleaning is detrimental to the properties of the gate oxide, which in turn affect the properties of the entire device.

Various procedures are used to clean silicon wafers. A widely-used procedure is the standard RCA clean. The RCA clean involves exposure to three separate solutions - SC1, HF, and SC2. An SC1 solution contains ammonium hydroxide, hydrogen peroxide, and water, and is generally effective at removing particles and metals from a silicon wafer surface. An SC2 solution contains hydrochloric acid, hydrogen peroxide, and water, and is generally effective at removing alkali ions as well as metal hydroxides that are insoluble in ammonium hydroxide. The HF strips any native oxide from the surface.

Many varieties of the RCA clean exist, but are still referred to as an RCA dean due to use of the SC1 and/or SC2 solution. A typical RCA clean involves the sequential steps of: HF → a deionized water rinse → SC1 → a deionized water rinse → SC2 → a deionized water rinse. It is also possible to perform the steps in different order, e.g., reversing the order of the HF and SC 1 steps, or to omit a step, e.g., omit the SC2 step.

A problem with RCA cleans, however, is that SC1 solutions have a tendency to cause roughening of the silicon surface, due to the presence of OH⁻ in the SC1 solution. (See Higashi and Chabal, "Silicon Surface Chemical Composition and Morphology," Handbook of Semiconductor Wafer Cleaning Technology, Noyes Publications (1993).) And it is possible for such roughening to interfere with device performance, particularly as device sizes and spacings become smaller.

Pre-gate cleans that do not roughen the silicon surface are therefore desirable.

### SUMMARY OF THE INVENTION

The invention provides a process involving an improved cleaning technique that results in a smoother surface than previous techniques. In particular, the cleaning technique of the invention involves a step of rinsing a silicon wafer with ozonated water. (Ozonated water typically comprises 5 to 20 ppm ozone dissolved in deionized water.) Typically, the cleaning technique involves the sequential steps of cleaning the silicon wafer with HF, performing the ozonated water rinse, and treating with an SC1 solution. It is possible to omit the initial HF cleaning step.

It is believed that the advantageous smoothness is attained as follows. Where an HF rinse is performed, the HF strips any native oxide from the silicon surface. The ozone induces formation of a more uniform chemical (as opposed to native) oxide layer, and this chemical oxide thus etches more uniformly in the SC1 than a native oxide. The resulting silicon thereby exhibits a surface smoothness higher than would be attained in an equivalent process without the ozonated water step. Where the HF rinse is omitted, the ozonated water similarly induces formation of an oxide layer that results in a more uniform etch by the SC1.

Subsequent device processing steps are thus able to be performed on a smoother surface than obtained by previous cleaning techniques, thereby contributing to improvement in the overall device.

### BRIEF DESCRIPTION OF THE DRAWINGS

Fig. 1 shows the initial surface of a silicon wafer.

Fig. 2 shows the surface of a silicon wafer after treatment according to the invention.

Fig. 3 shows the surface of a silicon wafer after a conventional treatment.

### DETAILED DESCRIPTION OF THE INVENTION

In one embodiment of the invention, a silicon wafer is treated as follows. First, the wafer is treated to an HF rinse. The concentration of HF is typically 0.5 to 10% HF in water. The HF is effective in removing any native oxide that may be present on the wafer. Such oxides (whether native or chemical) are normally present in commercially-obtained wafers. (Specifically, a wafer manufacturer generally leaves a native oxide in place or provides a chemical oxide to protect the silicon surface.) The HF rinse is performed by any suitable technique, e.g., dipping or spraying. (As noted above, it is possible to omit the HF rinse.)

Second, the wafer is treated - typically rinsed - with ozonated, deionized water. The dissolved O₃ in the ozonated water induces formation of a relatively uniform chemical oxide layer on the wafer. The oxide layer is generally about 8Å to about 12Å thick, and generally has a surface roughness that is substantially unchanged from that of the starting substrate. The ozonated water rinse is performed by any standard technique, including cycles of quick dump and/or overflow rinse. The particular technique, however, does not appear to impact the increased smoothness attained by the process of the invention.

Third, the wafer is treated with an SC1 solution. Typically the SC1 solution has a concentration ratio of 1:1:5 to 1:10:100 (NH₄OH:H₂O₂:H₂O), although it is possible to widely vary these relative concentrations and still attain a desired result. Control runs are easily performed to determine an appropriate ratio for a given set of process parameters. The SC1 removes particles, organics, and metals from the wafer surface, and is performed by any suitable technique.

Typically, an SC1 treatment would introduce some roughness into a wafer surface. But the presence of the chemical oxide layer induced by the ozonated water appears to keep the SC1 etch relatively uniform. Specifically, the native oxide found on a silicon wafer is less uniform than a chemically-formed oxide layer. Thus, it is believed the SC1 affects the native oxide in a non-uniform manner, resulting in increased surface roughness. In the invention, however, the presence of the more uniform chemical oxide layer tends to cause the SC1 etch to take place in a more uniform manner. (This is true even if the initial oxide is not removed by an HF rinse.) The process generally provides a silicon wafer with a surface roughness substantially unchanged from (typically identical to) that of the starting substrate.

The SC1 treatment is followed by a deionized water rinse. The wafer is then ready for gate oxide formation, and subsequent device formation steps, as is known in the art. (See, e.g., S.M. Sze, VLSI Technologies, McGraw-Hill (1988).)

Optionally, other pre-gate cleaning steps are performed, e.g., SC2 rinse. It is possible to use additional or alternative chemistries as well. For example, chemistries that provide the same result as the SC1 rinse, i.e., removal of particles, organics, and metals, are possible. Alkaline cleaning solutions, typically with a pH above 8.5, are typically suitable, e.g., tetramethylammonium hydroxide.

Thus, the ozonated water treatment is useful with a variety of techniques used for pre-gate cleans.

The invention will be further clarified by the following examples, which are intended to be exemplary.

### Example 1

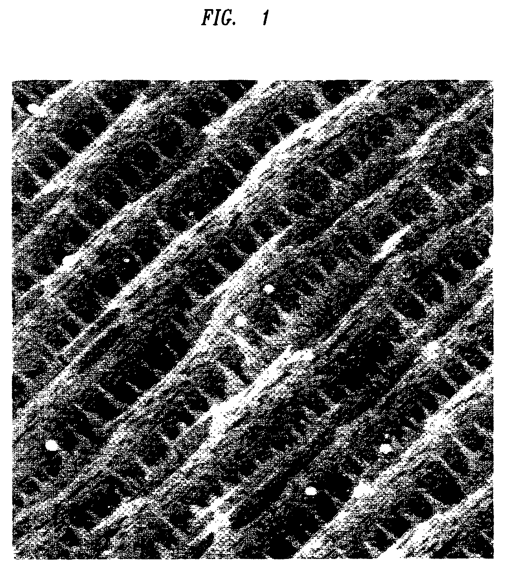

A silicon wafer with native oxide, having a surface roughness of 0.6 Å rms was obtained (as measured by atomic force microscopy - AFM). An AFM image of a 0.6 Å rms silicon wafer is shown in Fig. 1. (All AFM images in the examples cover an area of 2 µm x 2 µm and a height range of 1 nm.) The following process was performed:
(a) HF rinse (15:1 water to HF) at room temperature for 30 seconds;
(b) deionized ozonated water rinse (10 ppm ozone) for 10 minutes at room temperature, using an overflow rinse;
(c) SC1 rinse at a concentration ratio of 1:8:64 (NH₄OH:H₂O₂:H₂O) for 10 minutes at 65°C using a technique of SC1 immersion with megasonic energy; and
(d) deionized water rinse at room temperature for 10 minutes, using 6 cycles of overflow/quickdump rinse technique.

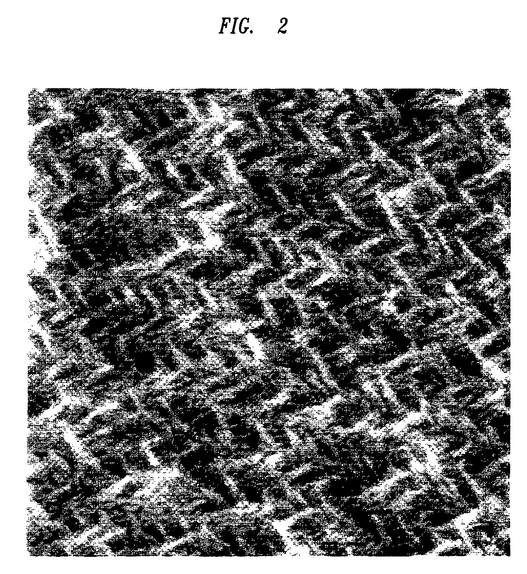

The resulting surface exhibited a surface roughness of 0.6 Å rms - the same as the initial surface, as shown in the AFM image of Fig. 2.

### Comparative Example 2

Using a silicon wafer having a surface roughness of 0.6 Å rms, such as shown in Fig. 1, the following process was performed:
(a) SC1 rinse at a concentration ratio of 1:8:64 (NH₄OH:H₂O₂:H₂O) for 10 minutes at 65°C using a technique of SC1 immersion with megasonic energy; and
(b) deionized water rinse at room temperature for 10 minutes, using 6 cycles of overflow/quickdump rinse technique;
(c) HF rinse (15:1 water to HF) at room temperature for 30 seconds;
(d) deionized water rinse at room temperature for 10 minutes, using 6 cycles of overflow/quickdump rinse technique.

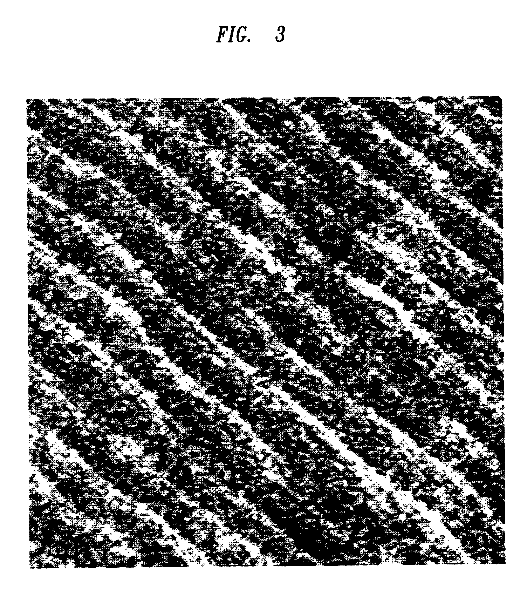

The resulting wafer exhibited a surface roughness of 1.0 Å rms, substantially higher than the initial roughness, as shown in the AFM image of Fig. 3.

Other embodiments of the invention will be apparent to those skilled in the art from consideration of the specification and practice of the invention disclosed herein.

## Claims

1. A process for fabricating an article, comprising the steps of: providing a silicon wafer;
treating the wafer with ozonated water, such that an oxide forms on the wafer surface; and
performing an etch of the treated wafer to substantially remove from the wafer surface at least one impurity selected from particles, organic materials, and metals.

2. The process of claim 1, wherein the ozonated water comprises deionized water and 5 to 20 ppm ozone.

3. The process of claim 1, wherein the etch is performed with an SC1 solution.

4. The process of claim 1, wherein an HF rinse of the wafer is performed prior to the ozonated water treatment.

5. The process of claim 1, wherein the process is performed in the absence of an HF rinse of the wafer.

6. The process of claim 1, wherein the surface roughness of the wafer after the etch is performed is the same as the roughness of the wafer prior to the treatment with the ozonated water.
